(19) Europäisches Patentamt
European Patent Office
Office européen des brevets

(11) **EP 2 325 896 B1**

(12) **EUROPEAN PATENT SPECIFICATION**

(45) Date of publication and mention
of the grant of the patent:
**30.10.2024 Bulletin 2024/44**

(21) Application number: **09813231.9**

(22) Date of filing: **09.09.2009**

(51) International Patent Classification (IPC):
**H01L 31/042** (2014.01)

(52) Cooperative Patent Classification (CPC):
**H01L 31/022433;** Y02E 10/50

(86) International application number:
**PCT/KR2009/005096**

(87) International publication number:
**WO 2010/030109 (18.03.2010 Gazette 2010/11)**

(54) **FRONT ELECTRODE FOR SOLAR CELL WHICH MINIMIZES POWER LOSS, AND SOLAR CELL INCLUDING THE SAME**

FRONTELEKTRODE FÜR EINE SOLARZELLE ZUR STROMVERLUSTMINIMIERUNG UND SOLARZELLE DAMIT

ELECTRODE FRONTALE POUR PILE SOLAIRE PERMETTANT DE RÉDUIRE LA PERTE DE PUISSANCE, ET PILE SOLAIRE COMPRENANT CETTE ÉLECTRODE

(84) Designated Contracting States:
**AT BE BG CH CY CZ DE DK EE ES FI FR GB GR HR HU IE IS IT LI LT LU LV MC MK MT NL NO PL PT RO SE SI SK SM TR**

(30) Priority: **12.09.2008 KR 20080090073**

(43) Date of publication of application:
**25.05.2011 Bulletin 2011/21**

(73) Proprietor: **LG Chem, Ltd.**
**Seoul 07336 (KR)**

(72) Inventors:
• **YOON, Seokhyun**
**Daejeon 305-340 (KR)**
• **HWANG, Inseok**
**Daejeon 305-340 (KR)**
• **KIM, Seung Wook**
**Yongin-si**
**Gyeonggi-do 446-976 (KR)**

(74) Representative: **Hoffmann Eitle**
**Patent- und Rechtsanwälte PartmbB**
**Arabellastraße 30**
**81925 München (DE)**

(56) References cited:
**EP-A2- 1 811 576      JP-A- 2005 101 273**
**JP-A- 2006 107 892      JP-A- H06 283 736**
**JP-A- H09 116 175      JP-U- S57 117 662**
**KR-A- 20060 065 009      KR-A- 20080 050 862**
**US-A1- 2002 084 503**

• **SHABANA M M ET AL: "OPTIMIZATION OF GRID DESIGN FOR SOLAR CELLS AT DIFFERENT ILLUMINATION LEVELS*", CHEMTRONICS, BUTTERWORTH SCIENTIFIC LTD. GUILDFORD, GB, vol. 4, no. 2, 1 June 1989 (1989-06-01), pages 97 - 99, XP000162967**

EP 2 325 896 B1

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

**[TECHNICAL FIELD]**

The present invention relates to solar cells having minimized power loss and including a front electrode, and, more particularly, to a solar cell wherein the front electrode is configured in a structure in which a pattern including a plurality of grid electrodes arranged in parallel and at least one current collection electrode intersecting the grid electrodes is formed on a semiconductor substrate, current introduced to the grid electrodes is moved to and collected in the current collection electrode, and the width of each of the grid electrodes is increased toward the current collection electrode.

**[BACKGROUND ART]**

In recent years, with increased concerns about environmental problems and depletion of nonrenewable energy sources, solar cells have drawn attention as an alternative energy source which uses abundant energy resources, is free of problems associated with pollution and has high energy efficiency.

Solar cells may be classified into solar thermal cells which generate steam energy necessary to rotate a turbine using solar heat and photovoltaic solar cells which convert photons into electric energy using properties of semiconductors. In particular, a great deal of research has focused on photovoltaic solar cells which absorb light, generating electrons and holes and thereby converting light energy into electric energy.

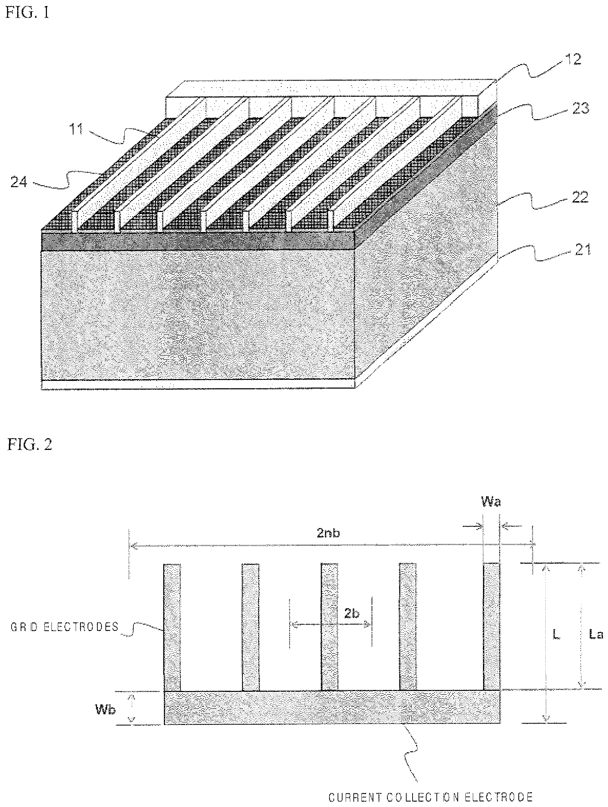

FIG. 1 is a view typically illustrating the structure of such a photovoltaic solar cell (hereinafter, simply referred to as a "solar cell"). Referring to FIG. 1, the solar cell includes a first conduction type semiconductor layer 22 and a second conduction type semiconductor layer 23, which is opposite to the conduction type of the first conduction type semiconductor layer 22, formed on first conduction type semiconductor layer 22. A pin junction is achieved at the interface between the first conduction type semiconductor layer 22 and the second conduction type semiconductor layer 23. A rear electrode 21 is disposed in contact with at least a portion of the first conduction type semiconductor layer 22, and a front electrode 11 is disposed in contact with at least a portion of the second conduction type semiconductor layer 23. According to circumstances, an anti-reflective film 24 to disturb light reflection may be formed at the top of the second conduction type semiconductor layer 23.

A p-type silicon substrate is usually used as the first conduction type semiconductor layer 22, and an n-type emitter layer is used as the second conduction type semiconductor layer 23. Also, the front electrode 11 is usually formed at the top of the emitter layer 23 using a silver (Ag) pattern, and the rear electrode 21 is usually formed at the bottom of the semiconductor layer 22 using an aluminum (Al) layer. The front electrode 11 and the rear electrode 21 are generally formed using a screen printing method. The front electrode generally includes two current collection electrodes (also referred to as 'bus bars') having a large width and grid electrodes (also referred to as 'fingers') having a small width of approximately 150 $\mu$m.

In the solar cell having the above structure, when solar light is incident on the front electrode 11, free electrons are generated. The electrons move to the n-type semiconductor layer 23 according to a pin conjunction principle. Such movement of the electrons generates current.

The performance of the solar cell which directly converts light energy into electric energy is expressed by a ratio of electric energy output from the solar cell to solar energy incident on the solar cell. This ratio indicates a performance index of the solar cell and is generally referred to as "energy conversion efficiency," or simply "conversion efficiency." Theoretically, conversion efficiency is limited by a material constituting a solar cell and is controlled according to matching of a spectrum of solar light energy and a sensitivity spectrum of a solar cell. For example, a single crystal silicon solar cell has a conversion efficiency of approximately 30 to 35 %, a noncrystalline silicon solar cell has a conversion efficiency of approximately 25 %, and a compound semiconductor solar cell has a conversion efficiency of approximately 20 to 40 %. On the present laboratory level, however, a solar cell has a conversion efficiency of approximately 25 %.

Loss may include loss caused by light reflected from a surface, loss caused by recombination of a carrier at the surface or an electrode interface, loss caused by recombination of the carrier in a solar cell, and loss caused by internal resistance of the solar cell.

Power loss caused by electrodes may include resistance loss caused by movement of light current at an n-type semiconductor layer, loss caused by contact resistance between the n-type semiconductor layer and grid electrodes, resistance loss caused by photoelectric current flowing in the grid electrodes, and loss caused by an area covered by the grid electrodes.

Consequently, there is a high necessity for technology that is capable of minimizing power loss caused by such electrodes and maximizing light absorption, thereby providing a solar cell exhibiting high efficiency.

JP-A-2006-107892 discloses a solar cell according to the preamble of claim 1.

JP-U-57-117662 describes an electrode arrangement for a solar cell in which a plurality of grid electrodes arranged in parallel have a width of 0.15 mm at their free ends and a width of 0.2 mm at the ends at which they are connected to a current collection electrode.

In the electrode arrangement of JP-A-6-283736, the width of grid electrodes increases towards a current collection electrode. A similar electrode configuration is known from the publication "Optimization of grid design for solar cells at different illumination levels", CHEMTRONICS, 1989, Vol. 4, June. EP-A2-1 811 576 shows an arrangement of grid electrodes which merge into larger grid electrodes which are in contact with collection electrodes.

**[DISCLOSURE]**

**[TECHNICAL PROBLEM]**

Therefore, the present invention has been made to solve the above problems, and other technical problems that have yet to be resolved.

Specifically, it is an object of the present invention to provide a front electrode for solar cells wherein the width of grid electrodes is adjusted to minimize power loss caused by the electrodes and maximize light absorption.

As a result of a variety of studies and experiments on a front electrode for solar cells, the inventors of the present application have found that, when the front electrode is configured so that the width of grid electrodes at a current collection electrode side is relatively large, electrode loss of the front electrode according to the present invention is much less than that of a conventional front electrode. The present invention has been completed based on these findings.

**[TECHNICAL SOLUTION]**

In accordance with one aspect of the present invention, the above and other objects can be accomplished by the provision of a solar cell comprising the features of claim 1.

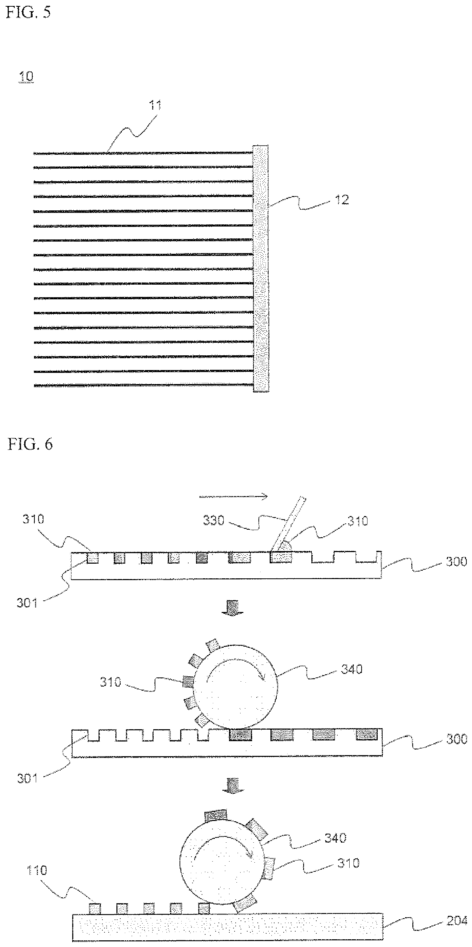

As shown in FIG. 5, conventional grid electrodes have a very large and uniform width of approximately 120 to 150 $\mu$m with the result that the area of regions (shadows) covered by the grid electrodes is large, resulting in high electrode loss. The inventors of the present application have considered a relationship between a loss of the grid electrodes and the size of the grid electrodes and the current collection electrode so as to develop a structure that is capable of minimizing a loss caused by the grid electrodes.

As previously discussed, electrode loss includes (1) a loss (loss I) caused when current flows in the n-type semiconductor layer, (2) a loss (loss II) caused when the current flows from the n-type semiconductor layer to the grid electrodes, (3) a loss (loss III) caused when the current flows in the grid electrodes, and (4) a loss (loss IV) caused by an area covered by the grid electrodes. The loss may be calculated as follows with reference to FIG. 2.

$$\text{Loss I} = \sim b^2 \sim n^{-2} \text{ x } R_s$$

$$\text{Loss II} = \sim b \text{ x } \rho_c^{1/2} \sim n^{-1} \text{ x } \rho_c^{1/2}$$

$$\text{Loss III} = \sim (L_a^2 \text{ x } b) / (t_a \text{ x } W_a) \sim L_a^2 \text{ x } n^{-1} \text{ x } W_a^{-2}$$

$$\text{Loss IV} = \sim W_a \text{ x } n$$

(In the above expressions, b indicates the intervals of the grid electrodes, n indicates the number of the grid electrodes, $\rho_c$ indicates contact specific resistance between the grid electrodes and the n-type semiconductor layer, $L_a$ indicates the length of the front electrode, $t_a$ indicates the thickness (height) of the grid electrodes, and $W_a$ indicates the width of the grid electrodes.)

From the above expressions, it can be seen that there are pairs of (n, $L_a$, $W_a$) in which the sum of the number (n) of the grid electrodes, the width ($W_a$) of the grid electrodes and the length ($L_a$) of the front electrode is minimized.

That is, as the width of the grid electrodes increases, the area of the shadows increases with the result that loss IV (hereinafter, also referred to as 'shadow loss' according to circumstances) increases, and therefore, light absorption is reduced. On the other hand, when the width of the grid electrodes is excessively small, electrode resistance increases with the result that loss III increases.

Meanwhile, since the amount of current flowing in the grid electrodes increases in an integral mode based on the length of the grid electrodes, it may be advantageous for the width of the grid electrodes to be small. When the length of the grid electrodes is equal to or greater than a predetermined length, however, it is preferable for the width of the grid electrodes to be small in consideration of resistance.

According to the present invention, therefore, the grid electrodes are configured to have a structure in which the width of the grid electrodes is increased toward the current collection electrode at which the amount of current increases. Also, it is preferable for the grid electrodes to be at right angles to the current collection electrode in consideration of efficiency per unit area.

The width of each of the grid electrodes may be increased so that the width of each of the grid electrodes at one end thereof adjacent to the current collection electrode is preferably 50 to 500 %, more preferably 200 to 500 %, greater than the width of each of the grid electrodes at the other end thereof distant from the current collection electrode.

According to the invention, the width of each of the grid electrodes is discontinuously increased in inverse proportion to the distance from the current collection electrode.

The width of each of the grid electrodes may be discontinuously increased, for example, in a stair type structure or in a basin type structure.

The pattern includes a first pattern part at which the width of each of the grid electrodes is 150 $\mu$m or less and a second pattern part at which the width of each of the grid electrodes is less than that of each of the grid electrodes at the first pattern part.

Seeing as the front electrode is configured to have such a combination type structure having a first pattern part at which the width of each of the grid electrodes is relatively large and a second pattern part at which the width of each of the grid electrodes is relatively small as described above, it is possible to effectively deal with the amount of current cumulatively increasing based on the length of the grid electrodes, thereby minimizing loss due to the increase in current resistance.

To this end, it is preferable to form the first pattern part at the grid electrodes located at the current collection electrode at which the amount of current increases so that the first pattern part has a predetermined length. Also, it is preferable for the grid electrodes to be at right angles to the current collection electrode in consideration of efficiency per unit area. Preferably, the width of the current collection electrode is approximately 1.5 to 3 mm, and two current collection electrodes are provided so that the current collection electrodes are spaced apart from each other by a predetermined distance.

The second pattern part is configured to have a structure in which two or more grid electrodes are joined to each other. As a result, the grid electrodes, having the relatively small width, of the second pattern part are connected to the grid electrodes of the first pattern part while the grid electrodes of the second pattern part are joined to each other, and therefore, it is possible to lower power loss caused during movement of current between the first pattern part and the second pattern part to a negligible level.

The structure in which the grid electrodes are joined to each other at the second pattern part is a dendrite structure in which end connection is achieved between the grid electrodes of the first pattern part and the grid electrodes of the second pattern part. Hereinafter, the electrodes to interconnect the grid electrodes of the first pattern part and the grid electrodes of the second pattern part will be referred to as dendrite electrodes.

It is preferable for the width of the grid electrodes at the first pattern part and the second pattern part to be adjusted so that the increase of resistance due to current accumulation is minimized while shadow loss due to the grid electrodes is minimized.

The second pattern part is a portion to which current is introduced, and therefore, current accumulation is low. In order to minimize the shadow loss, therefore, it is preferable for the grid electrodes to have a relatively small width. If the width of the grid electrodes is excessively small, however, it is difficult to form the grid electrodes and, in addition, resistance increases.

Also, the first pattern part is a portion from which current is discharged to the current collection electrode (also functioning as a current introduction portion according to circumstances). In order to minimize the increase of resistance due to current accumulation, therefore, it is preferable for the grid electrodes to have a relatively large width. If the width of the grid electrodes is excessively large, however, shadow loss is caused and materials are wasted.

In consideration of the above matters, therefore, the width of each of the dendrite electrodes may be one to two times, preferably 1 to 1.5 times, that of each of the grid electrodes of the second pattern part.

Also, the width of each of the grid electrodes of the first pattern part may be 1.1 to 15 times, preferably 3 to 5 times, that of each of the grid electrodes of the second pattern part within a range greater than that of each of the dendrite electrodes.

In a preferred example, the width of each of the grid electrodes of the second pattern part may be 10 to 60 $\mu$m, preferably 10 to 40 $\mu$m, and the width of each of the grid electrodes of the first pattern part may be 50 to 150 $\mu$m, preferably 60 to 100 $\mu$m, within a range greater than that of each of the grid electrodes of the second pattern part.

The width of each of the dendrite electrodes may be equal to that of each of the grid electrodes of the second pattern part or 10 to 60 $\mu$m, preferably 10 to 50 $\mu$m, within a range greater than that of each of the grid electrodes of the second pattern part.

Meanwhile, if the intervals of the grid electrodes are large, movement distance of current from the n-type semiconductor layer to the grid electrodes is increased, resulting in current loss. If the intervals of the grid electrodes are excessively small, on the other hand, shadow loss is increased.

Since the width of each of the grid electrodes at the second part is less than that of each of the conventional grid electrodes, shadow loss is not increased even when the intervals of the grid electrodes, which are approximately 2.5 to 3 mm in the conventional art, are reduced. Furthermore, the movement distance of current is decreased, thereby further improving efficiency. Since the grid electrodes of the first pattern part have a greater width than those of the second pattern part, on the other hand, it is preferable to set the intervals of the grid electrodes at the first pattern part so that the intervals of the grid electrodes at the first pattern part are not much less than those of the grid electrodes at the second pattern part in order to minimize shadow loss. For example, the intervals of the grid electrodes of the first pattern part may be 0.7 to 6 times, preferably 1 to 3 times, those of the grid electrodes of the second pattern part.

In a preferred example, the intervals of the grid electrodes of the second pattern part may be 0.5 to 2 mm, and the intervals of the grid electrodes of the first pattern part may be equal to those of grid electrodes of the second pattern part or 1.5 to 3 mm within a range greater than those of the grid electrodes of the second pattern part.

The dendrite electrodes are preferably inclined at an angle of 30 to 70 degrees to the longitudinal direction of the grid electrodes.

Also, if the length of the second pattern part is greater than 70 % the total length of the grid electrodes or the length of the first pattern part is less than 30 % the total length of the grid electrodes, current resistance is excessively increased. On the other hand, if the length of the second pattern part is less than 10 % the total length of the grid electrodes or the length of the first pattern part is greater than 90 % the total length of the grid electrodes, shadow loss is increased.

Consequently, the length of each of the grid electrodes of the second pattern part is preferably 10 to 70 % the total length of each of the grid electrodes. Also, it is preferable for the length of each of the grid electrodes of the first pattern part to be 30 to 90 % the total length of each of the grid electrodes. If the length of each of the dendrite electrodes is large, the length of each of the grid electrodes is excessively increased. Consequently, the length of each of the dendrite electrodes is preferably 10 % or less of the total length of each of the grid electrodes.

The semiconductor substrate may include an n-type semiconductor layer formed of crystalline silicon. According to circumstances, various kinds of layers may be added to the semiconductor substrate. For example, an anti-reflective film may be applied to the top of a dopant layer of an N+ semiconductor layer. Silicon nitride or silicon oxide may be used as the anti-reflective film.

Also, it is preferable to increase the resistance of the n-type semiconductor layer in order to reduce surface recombination velocity of photoelectric current. The resistance of the n-type semiconductor layer may be 50 Ω or more, preferably 100 Ω or more.

In the solar cell according to the present invention, the structure of the grid electrodes is optimized with the result that the solar cell has an electrode loss of 1.3 mW/cm$^2$ or less. Consequently, the solar cell according to the present invention has an advantage in that conversion efficiency is very high.

The solar cell may be formed of a bulk type material. Preferably, the solar cell is formed of crystalline silicon in consideration of efficiency. The structure and manufacturing method of the solar cell are well known in the art to which the present invention pertains, and therefore, a detailed description thereof will not be given.

In accordance with a further aspect of the present invention, there is provided a method of manufacturing a front electrode for solar cells. Conventional front electrodes are manufactured using a screen printing method. In the screen printing method, ink is pushed between screen masks to print the front electrodes. The screen printing method has a precision of approximately 100 $\mu$m, and therefore, it is not possible to achieve a pattern of less than 100 $\mu$m using the screen printing method, with the result that electrode loss is high. Also, ink is pushed through squeezing with the result that the screen printing method is not suitable for a continuous process.

In order to solve such problems, upon forming a pattern including a plurality of grid electrodes arranged in parallel and a current collection electrode intersecting the grid electrodes on a semiconductor substrate, the manufacturing method according to the present invention includes printing paste on a semiconductor substrate using a gravure printing method or an offset printing method so that the grid electrodes have a width of 100 $\mu$m or less and (b) heating and/or pressurizing the paste to harden the paste.

When the front electrode is formed using the gravure printing method or the offset printing method as described above, it is possible to easily form a micrometer scale pattern and to form the pattern through a continuous process, thereby greatly improving process efficiency.

As a concrete example, the offset printing method may include (i) preparing a printing substrate having grooves formed in a predetermined pattern corresponding to that of the front electrode, (ii) filling the grooves formed at the printing substrate with paste for electrode formation, (iii) rotating a printing roll on the printing substrate to transfer the paste placed in the grooves to the printing roll, and (iv) rotating the printing roll on a semiconductor substrate to transfer the paste from the printing roll to the semiconductor substrate.

The offset printing method has a patterning precision of approximately 10 to 20 $\mu$m, and the thickness of a pattern formed using the offset printing method is merely several $\mu$m. Consequently, the offset printing method has an advantage of forming a pattern having a sub-micrometer size. Also, in the offset printing method, the paste is transferred to the substrate using the printing roll. Consequently, it is possible to form a pattern through a single transfer process using a printing roll having a size corresponding to the area of the substrate even when the area of the substrate is large.

As another example, the gravure printing method may include (i) preparing a blanket cylinder having grooves formed in a predetermined pattern corresponding to that of the front electrode, (ii) filling the grooves formed at the blanket cylinder with paste for electrode formation, and (iii) rotating the blanket cylinder on a semiconductor substrate to transfer the paste from the blanket cylinder to the semiconductor substrate.

It is also possible to print a pattern having a sub-micrometer size using the gravure printing method. Consequently, the gravure printing method has an advantage of suitably forming a micrometer scale pattern and of simultaneously patterning a large area in the same manner as the offset printing method.

In the method of manufacturing the front electrode according to the present invention, the paste contains a material used to form the grid electrodes and the current collection electrode constituting the front electrode. Preferably, the paste contains silver (Ag) powder.

Meanwhile, the step of curing the paste may include preliminarily drying the paste at a temperature of 150 to 200 °C, removing a binder at a temperature of 400 to 5200 °C, and sintering the paste at a temperature of 750 to 850 °C. The total time necessary to cure the paste may be 5 to 10 minutes.

[BRIEF DESCRIPTION OF THE DRAWINGS]

The above and other objects, features and other advantages of the present invention will be more clearly understood from the following detailed description taken in conjunction with the accompanying drawings, in which:

FIG. 1 is a partial perspective view illustrating a conventional solar cell,

FIG. 2 is a typical view illustrating a front electrode for solar cells;

FIG. 3 is a partial plan view illustrating a second type front electrode according to an embodiment of the present invention;

FIG. 4 is a partial plan view illustrating a second type front electrode according to another embodiment of the present invention;

FIG. 5 is a partial plan view illustrating a conventional front electrode;

FIG. 6 is a typical view illustrating a process of forming a pattern using an offset printing method according to an embodiment of the present invention;

FIG. 7 is a partial perspective view illustrating a solar cell having the front electrode of FIG. 3;

FIG. 8 is a plan view of the solar cell having the front electrode of FIG. 3; and

FIGS. 9 and 10 are graphs illustrating power loss according to experimental examples of the present invention.

<Description of Main Reference Numerals of the Drawings>

| 11, 110: | Grid electrodes | 12, 120: | Current collection electrodes |
|---|---|---|---|
| 21, 201: | Rear electrodes | 22, 202: | P-type semiconductor layers |
| 23, 203: | n-type semiconductor layers | 24, 204: | Anti-reflective films |

[BEST MODE]

Now, preferred embodiments of the present invention will be described in detail with reference to the accompanying drawings. It should be noted, however, that the scope of the present invention is not limited by the illustrated embodiments.

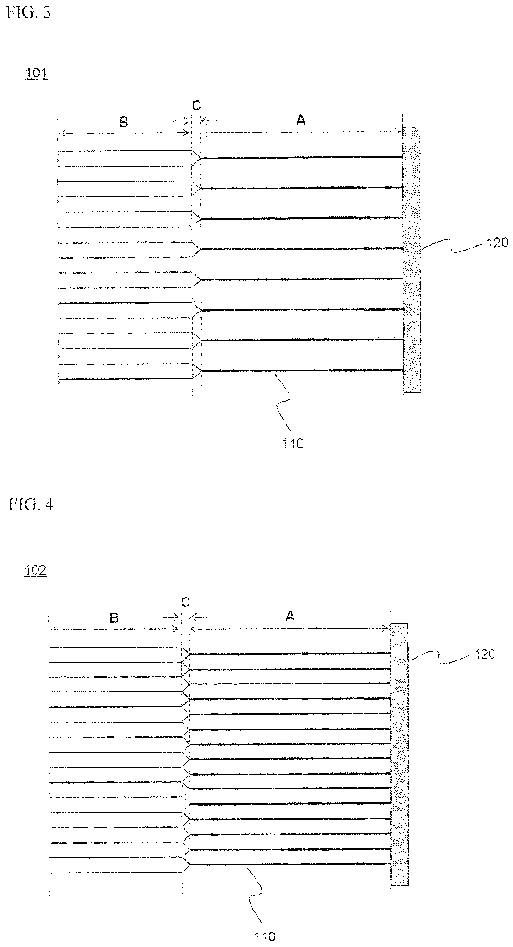

FIGS. 3 and 4 are partial plan views typically illustrating front electrodes according to embodiments of the present invention.

Referring to these drawings, each grid electrode 110 includes a first pattern part A adjacent to a current collection electrode 120, a second pattern part B distant from the current collection electrode 120, and a dendrite electrode C located between the first pattern part A and the second pattern part B. The first pattern part A. At the first pattern part A, grid electrodes each having a relatively large width are arranged at large intervals. At the second pattern part B, on the other hand, grid electrodes each having a relatively small width are arranged at small intervals.

In the above structure, the amount of current introduced is maximized by the second pattern part B, whereas current resistance and shadow loss are minimized by the first pattern part A.

At the front electrode shown in FIG. 3, every two grid electrodes of the second pattern part are joined to each other via each dendrite electrode C. At the front electrode shown in FIG. 4, all grid electrodes of the second pattern part are joined to each other via the corresponding dendrite electrodes C. For the front electrode of FIG. 4, the grid electrodes at the first pattern part are arranged at relatively small intervals. In consideration of a shadow loss, therefore, the grid electrodes may have a smaller width than the grid electrodes at the first pattern part of FIG. 3.

FIG. 5 is a typical view illustrating a process of manufacturing a front electrode using an offset printing method according to an embodiment of the present invention.

Referring to FIG. 6, first, grooves 301 having a shape corresponding to a pattern of a front electrode to be formed at a semiconductor substrate are formed at a printing substrate 300. At this time, a method of forming the grooves 301 is not particularly restricted. For example, the grooves 301 may be formed using a well-known method, such as photolithography. Subsequently, the interiors of the grooves 301 are filled with paste 310 for electrode formation. To this end, the paste 310 is applied to the surface of the printing substrate 300, and a doctor blade 330 is moved in a state in which the doctor blade 330 is in contact with the printing substrate 300. With the movement of the doctor blade 330, the interiors of the grooves 301 are filled with the paste 310. On the other hand, the remaining paste 310 may be removed from the printing substrate 300 by the doctor blade 330.

Subsequently, the paste 310 placed in the grooves 301 of the printing substrate 300 is transferred to the surface of a printing roll 340, which is rotated in a state in which the printing roll 340 is in contact with the printing substrate 300. The printing roll 340 may have the same width as a semiconductor substrate 204 at which a pattern is to be formed. Also, the printing roll 340 may have a circumference equal to the length of the semiconductor substrate 204. Consequently, all of the paste 310 placed in the grooves 301 of the printing substrate 300 is transferred to the circumferential surface of the printing roll 340 by a single rotation of the printing roll 340.

Subsequently, the printing roll 340 is rotated in a state in which the printing roll 340 is in contact with the surface of the semiconductor substrate 204. As a result, the paste 310 is transferred from the printing roll 340 to the semiconductor substrate 204. Subsequently, the paste transferred to the semiconductor substrate 204 is cured to form a pattern.

When the front electrode is patterned using the offset printing method as described above, it is possible to easily form a micrometer scale pattern. In addition, the printing substrate 300 and the printing roll 340 are manufactured so as to correspond to the size of the semiconductor substrate 204. Consequently, it is possible to form the pattern through a single transfer process, thereby greatly improving process efficiency.

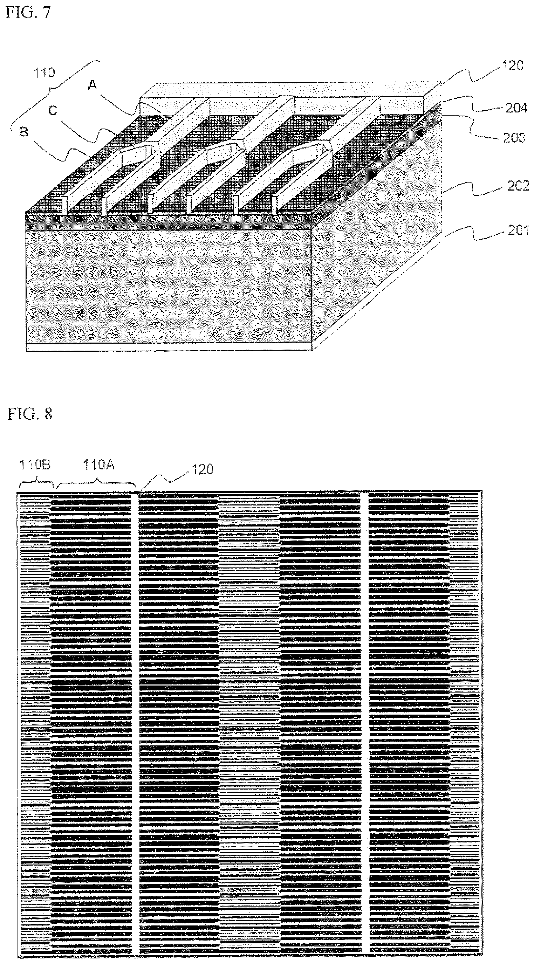

FIG. 7 is a partial perspective view typically illustrating a solar cell having the front electrode of FIG. 3.

Referring to FIG. 7, the solar cell include a p-type semiconductor layer 202 and an n-type semiconductor layer 203, which is opposite to the conduction type of the p-type semiconductor layer 202, formed on the p-type semiconductor layer 202. A pin junction is achieved at the interface between the p-type semiconductor layer 202 and the n-type semiconductor layer 203. A rear electrode 201 is formed at the bottom of the p-type semiconductor layer 202. An anti-reflective film 204 having a honeycomb structure to disturb light reflection is formed at the top of the n-type semiconductor layer 203. A front electrode 110 including grid electrodes and a current collection electrode 120 is formed on the anti-reflective film 204 in a state in which the front electrode is in contact with at least a portion of the n-type semiconductor layer 203.

A p-type silicon substrate is usually used as the p-type semiconductor layer 202, and a phosphorous (P)-doped n-type emitter layer is used as the n-type semiconductor layer 203. Also, the front electrode 110 is usually formed of a silver (Ag) pattern, and the rear electrode 210 disposed at the bottom of the p-type semiconductor layer 202 is usually formed of an aluminum (Al) layer.

The front electrode includes a first pattern part 110A including grid electrodes perpendicularly connected to the current collection electrode 120, which has a large width, each of the grid electrodes having a width of 150 $\mu$m or less, a second pattern part 110B including grid electrodes having a smaller width than the grid electrodes of the first pattern part A, and dendrite electrodes 110C including grid electrodes interconnecting the grid electrodes of the first pattern part 110A and the grid electrodes of the second pattern part 110B.

In the above structure, the increase in resistance of current, introduced from the n-type semiconductor layer 203 to the second pattern part B, flowing in the grid electrodes 110 is minimized by the first pattern part A. In addition, the intervals of the grid electrodes at the first pattern part 110A are configured to be large, and the intervals of the grid electrodes at the second pattern part 110B are configured to be small, thereby minimizing power loss.

FIG. 8 is a plan view typically illustrating a front electrode of a solar cell according to the present invention.

Referring to FIG. 8, the front electrode is configured to have a structure in which grid electrodes are arranged between two current collection electrodes 120 so that the grid electrodes are perpendicular to the current collection electrodes 120. First pattern parts 110A having a relatively large thickness are connected to the respective current collection electrodes 120 so that the first pattern parts 110A are perpendicular to the current collection electrodes 120. Also, second pattern parts 110B are connected to the respective first pattern parts 110A. The first pattern parts 110A and the second pattern parts 110B are connected to each other in a middle portion defined between the two current collection electrodes 120.

Hereinafter, the present invention will be described in more detail with reference to the following examples. These examples are provided only for illustrating the present invention and should not be construed as limiting the scope of the present invention.

[Example 1]

Phosphorous (P) was diffused on a crystalline p-type silicon substrate to form an n layer having a resistance of 50 ohm, and an anti-reflective silicon nitride (SiNx) layer was deposited at the front of the n layer. Aluminum (Al) paste was screen printed and hardened on the rear of the substrate having the p-n junction as described above to form a rear electrode layer, and an electrode was formed at the front of the n layer in the shape shown in FIG. 3 through an offset printing method using silver (Ag) paste. Specifically, grid electrodes of a first pattern part A were formed to have a length of 2.6 cm, and grid electrodes of a second pattern part B were formed to have a length of 1 cm. The grid electrodes of the first pattern part A were formed to have a width of 90 $\mu$m and intervals of 1 mm. Dendrite electrodes C were formed to have a length of 0.05 cm. A solar cell having a resistance of 50 ohm at the n layer was manufactured using the electrode formed as described above.

[Example 2]

A solar cell having a resistance of 100 ohm at an n layer was manufactured using the same method as in Example 1 except that the grid electrodes of the first pattern part were formed to have a length of 2.4 cm, the grid electrodes of the second pattern part were formed to have a length of 1.2 cm, the grid electrodes of the first pattern part were formed to have a width of 20 $\mu$m and intervals of 0.83 mm, and the dendrite electrodes C were formed to have a length of 0.05 cm.

[Comparative example 1]

Grid electrodes were formed into a shape as shown in FIG. 5 to have a width of 120 $\mu$m and intervals of 2.5 mm, thereby manufacturing a solar cell having a resistance of 50 ohm at an n layer.

[Comparative example 2]

Grid electrodes were formed to have a width of 20 $\mu$m and intervals of 1 mm into a shape as shown in FIG. 5, thereby manufacturing a solar cell having a resistance of 50 ohm at an n layer.

[Comparative example 3]

Grid electrodes were formed into a shape as shown in FIG. 5 to have a width of 120 $\mu$m and intervals of 2.5 mm, thereby manufacturing a solar cell having a resistance of 100 ohm at an n layer.

[Comparative example 4]

Grid electrodes were formed to have a width of 20 $\mu$m and intervals of 1 mm into a shape as shown in FIG. 5, thereby manufacturing a solar cell having a resistance of 100 ohm at an n layer.

<Table 1>

| | Length of grid electrodes (cm) | | Width of grid electrodes ($\mu$m) | | Intervals of grid electrodes (mm) | | Resistance of n layer (ohm) |
|---|---|---|---|---|---|---|---|
| | First pattern part | Second pattern part | First pattern part | Second pattern part | First pattern part | Second pattern part | |
| Example 1 | 2.6 | 1.0 | 90 | 20 | 2 | 1 | 50 |
| Example 2 | 2.4 | 1.2 | 90 | 20 | 1.7 | 0.83 | 100 |
| Comparative example 1 | 3.6 | | 120 | | 2.5 | | 50 |
| Comparative example 2 | 3.6 | | 20 | | 1 | | 50 |
| Comparative example 3 | 3.6 | | 120 | | 2.5 | | 100 |
| Comparative example 4 | 3.6 | | 20 | | 1 | | 100 |

[Experimental example 1]

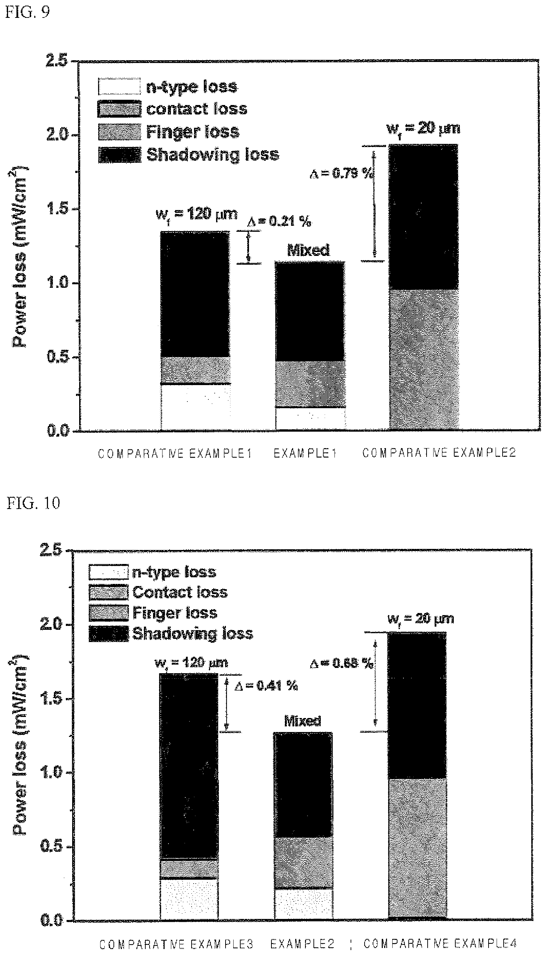

Power losses of the solar cells manufactured according to Examples 1 and 2 and Comparative examples 1 to 4 were calculated. The results are indicated in FIGS. 9 and 10 and Table 2 below.

<Table 2>

| | n-type loss | Contact loss | Finger loss | Shadow loss | Total loss | Difference of loss from Comparative example 1 (3) | Difference of loss from Comparative example 2 (4) |
|---|---|---|---|---|---|---|---|
| Example 1 | 0.16 | 0.003 | 0.31 | 0.67 | 1.14 | 0.21 % | 0.79 % |
| Example 2 | 0.21 | 0.003 | 0.35 | 0.70 | 1.26 | 0.41 % | 0.68 % |
| Comparative example 1 | 0/32 | 0.003 | 0.18 | 0.94 | 1.35 | - | - |
| Comparative example 2 | 0.007 | 0.005 | 0.95 | 0.98 | 1.93 | - | - |
| Comparative example 3 | 0.28 | 0.003 | 0.12 | 1.26 | 1.67 | - | - |
| Comparative example 4 | 0.01 | 0.0007 | 0.95 | 0.98 | 1.94 | - | - |

In Table 2, the n-type loss (loss I) is caused when current flows in the n-type semiconductor layer, the contact loss (loss II) is caused when the current flows from the n-type semiconductor layer to the grid electrodes, the finger loss (loss III) is caused when the current flows in the grid electrodes, and the shadow loss (loss IV) is caused by an area covered by the grid electrodes.

Also, in Table 2. the differences of loss between Examples and Comparative examples were based on the same resistance of the emitter (the same resistance of the n layer). That is, Example 1 was compared with Comparative examples 1 and 2 having an emitter resistance of 50 ohm, and Example 2 was compared with Comparative examples 3 and 4 having an emitter resistance of 50 ohm.

First, referring to FIG. 9 and Table 2, it can be seen that the power loss of the solar cell of Example 1 having the front electrode according to the present invention was much less than that of the solar cell of Comparative examples 1 and 2.

Specifically, it can be seen that, for the battery of Comparative example 2, the grid electrodes were excessively thin and arranged at small intervals, and therefore, the resistance of current flowing in the grid electrodes was increased with the result that loss III was very high, whereas loss III was greatly reduced for the battery of Example 1. Also, it can be seen that, for the battery of Comparative example 1, the grid electrodes had a large width and large intervals, and therefore, shadow loss was very high, whereas the shadow loss was greatly reduced for the battery of Example 1.

The power loss of the battery of Example 1 was 0.21 % lower than that of battery of Comparative example 1 and 0.79 % lower than that of battery of Comparative example 2.

Also, referring to FIG. 10 and Table 2, it can be seen that, when the n-type semiconductor layer having a resistance of 100 ohm was formed, power loss of the battery according to the present invention was much less (0.41 % less) than that of the conventional battery (Comparative example 3). Consequently, it can be seen that the front electrode according to the present invention can be preferably applied to even in a case in which a high-resistance n-type semiconductor layer is used so as to reduce surface recombination velocity of current.

**[INDUSTRIAL APPLICABILITY]**

As is apparent from the above description, the front electrode for solar cells according to the present invention is configured to have a structure in which the width of the grid electrodes is increased toward the current collection electrode, thereby minimizing the increase of resistance while minimizing shadow loss and thus reducing power loss. Consequently, it is possible to manufacture a solar cell exhibiting high efficiency.

**Claims**

1. A solar cell comprising a front electrode (110), wherein the front electrode (110) is configured in a structure in which a pattern comprising a plurality of grid electrodes arranged in parallel and at least one current collection electrode (120) intersecting the grid electrodes is formed on a semiconductor substrate (202, 203), current introduced to the grid electrodes is moved to and collected in the current collection electrode (120), and the width of each of the grid electrodes is increased toward the current collection electrode (120),

   wherein the width of each of the grid electrodes is discontinuously increased in inverse proportion to the distance from the current collection electrode (120), and wherein
   the pattern comprises a first pattern part (110A) and a second pattern part (1 10B) at which the width of each of the grid electrodes is less than that of each of the grid electrodes at the first pattern part (1 10A),
   **characterized in that**
   the grid electrodes of the first pattern part (110A) and the grid electrodes of the second pattern part (110B) extend along a longitudinal direction of the grid electrodes,
   at the first pattern part (110A), the width of each of the grid electrodes is 150 $\mu$m or less, and
   dendrite electrodes (110C) are located between the grid electrodes of the first pattern part (110A) and the grid electrodes of the second pattern part (110B) to interconnect two or more grid electrodes of the second pattern part (110B) with each grid electrode of the first pattern part (1 10A).

2. The solar cell according to claim 1, wherein the grid electrodes are at right angles to the current collection electrode (120).

3. The solar cell according to claim 1, wherein the width of each of the grid electrodes is increased so that the width of each of the grid electrodes at one end thereof adjacent to the current collection electrode (120) is 50 to 500 % greater than the width of each of the grid electrodes at the other end thereof distant from the current collection electrode (120).

4. The solar cell according to claim 1, wherein the width of each of the dendrite electrodes (11 0C) is one to two times that of each of the grid electrodes of the second pattern part (110B).

5. The solar cell according to claim 1, wherein the width of each of the grid electrodes of the first pattern part (110A) is 1.1 to 15 times that of each of the grid electrodes of the second pattern part (110B) within a range greater than that of each of the dendrite electrodes (110C).

6. The solar cell according to claim 1, wherein the length of each of the grid electrodes of the second pattern part (110B) is 10 to 70 % the total length of each of the grid electrodes, the length of each of the grid electrodes of the first pattern part (110A) is 30 to 90 % the total length of each of the grid electrodes, and the length of each of the dendrite electrodes (110C) is 10 % or less of the total length of each of the grid electrodes.

7. A method of manufacturing a solar cell comprising a front electrode (110) according to claim 1, wherein, upon forming a pattern comprising a plurality of grid electrodes arranged in parallel and a current collection electrode (120) intersecting the grid electrodes on a semiconductor substrate (202, 203), the method comprises:

    (a) printing paste on a semiconductor substrate (202, 203) using a gravure printing method or an offset printing method so that the grid electrodes have a width of 100 $\mu$m or less; and
    (b) heating and/or pressurizing the paste to harden the paste.

8. The method according to claim 7, wherein the offset printing method comprises: preparing a printing substrate having grooves formed in a predetermined pattern corresponding to that of the front electrode (110); filling the grooves formed at the printing substrate with paste for electrode formation; rotating a printing roll on the printing substrate to transfer the paste placed in the grooves to the printing roll; and rotating the printing roll on a semiconductor substrate (202, 203) to transfer the paste from the printing roll to the semiconductor substrate (202, 203).

9. The method according to claim 7, wherein the gravure printing method comprises: preparing a blanket cylinder having grooves formed in a predetermined pattern corresponding to that of the front electrode (110); filling the grooves formed at the blanket cylinder with paste for electrode formation; and rotating the blanket cylinder on a semiconductor substrate (202, 203) to transfer the paste from the blanket cylinder to the semiconductor substrate (202, 203).

**Patentansprüche**

1. Solarzelle, umfassend eine Frontelektrode (110), wobei die Frontelektrode (110) in einer Struktur konfiguriert ist, in der ein Muster, das eine Vielzahl von Gitterelektroden umfasst, parallel angeordnet ist und mindestens eine Stromsammlungselektrode (120), die die Gitterelektroden kreuzt, auf einem Halbleitersubstrat (202, 203) gebildet ist, Strom, der in die Gitterelektroden eingeleitet wurde, zu der Stromsammlungselektrode (120) bewegt und dort gesammelt wird und die Breite von jeder der Gitterelektroden zu der Stromsammlungselektrode (120) hin vergrößert wird,

    wobei die Breite von jeder der Gitterelektroden nicht kontinuierlich in umgekehrter Proportion zum Abstand von der Stromsammlungselektrode (120) vergrößert wird, und wobei
    das Muster einen ersten Musterteil (110A) und einen zweiten Musterteil (110B) umfasst, in dem die Breite von jeder der Gitterelektroden geringer ist als die von jeder der Gitterelektroden im ersten Musterteil (110A),
    **dadurch gekennzeichnet, dass**
    sich die Gitterelektroden des ersten Musterteils (110A) und die Gitterelektroden des zweiten Musterteils (110B) entlang einer Längsrichtung der Gitterelektroden erstrecken,
    im ersten Musterteil (110A) die Breite von jeder der Gitterelektroden 150 $\mu$m oder weniger ist, und
    Dendritelektroden (110C) zwischen den Gitterelektroden des ersten Musterteils (110A) und den Gitterelektroden des zweiten Musterteils (110B) positioniert sind, um zwei oder mehrere Gitterelektroden des zweiten Musterteils (110B) mit jeder Gitterelektrode des ersten Musterteils (110A) zu verbinden.

2. Solarzelle nach Anspruch 1, wobei die Gitterelektroden in rechten Winkeln zu der Stromsammlungselektrode (120) stehen.

3. Solarzelle nach Anspruch 1, wobei die Breite von jeder der Gitterelektroden so vergrößert wird, dass die Breite von jeder der Gitterelektroden an einem Ende davon angrenzend zu der Stromsammlungselektrode (120) um 50 bis 500 % größer ist als die Breite von jeder der Gitterelektroden an dem anderen, von der Stromsammlungselektrode (120) entfernten Ende.

4. Solarzelle nach Anspruch 1, wobei die Breite von jeder der Dendritelektroden (110C) ein- oder zweimal die von jeder der Gitterelektroden des zweiten Musterteils (110B) ist.

5. Solarzelle nach Anspruch 1, wobei die Breite von jeder der Gitterelektroden des ersten Musterteils (110A) 1,1- bis 15-mal die von jeder der Gitterelektroden des zweiten Musterteils (110B) innerhalb eines Bereichs ist, der größer ist als der von jeder der Dendritelektroden (110C).

6. Solarzelle nach Anspruch 1, wobei die Länge von jeder der Gitterelektroden des zweiten Musterteils (110B) 10 bis

**EP 2 325 896 B1**

70 % der Gesamtlänge von jeder der Gitterelektroden ist, die Länge von jeder der Gitterelektroden des ersten Musterteils (110A) 30 bis 90 % der Gesamtlänge von jeder der Gitterelektroden ist, und die Länge von jeder der Dendritelektroden (110C) 10 % oder weniger der Gesamtlänge von jeder der Gitterelektroden ist.

**7.** Verfahren zum Herstellen einer Solarzelle, die eine Frontelektrode (110) nach Anspruch 1 umfasst, wobei nach Bilden eines Musters, das eine Vielzahl von Gitterelektroden umfasst, die parallel angeordnet ist und eine Stromsammlungselektrode (120) die Gitterelektroden auf einem Halbleitersubstrat (202, 203) kreuzt, wobei das Verfahren Folgendes umfasst:

(a) Drucken einer Paste auf ein Halbleitersubstrat (202, 203) unter Verwendung eines Tiefdruckverfahrens oder eines Offsetdruckverfahrens so, dass die Gitterelektroden eine Breite von 100 μm oder weniger aufweisen; und
(b) Erwärmen und/oder Druckbeaufschlagen der Paste, um die Paste auszuhärten.

**8.** Verfahren nach Anspruch 7, wobei das Offsetdruckverfahren Folgendes umfasst: Vorbereiten eines Drucksubstrats, das Rillen aufweist, die in einem vorbestimmten Muster gebildet sind, das dem der Frontelektrode (110) entspricht; Füllen der in dem Drucksubstrat gebildeten Rillen mit Paste zur Elektrodenbildung; Drehen einer Druckwalze auf dem Drucksubstrat, um die in den Rillen positionierte Paste auf die Druckwalze zu übertragen; und Drehen der Druckwalze auf einem Halbleitersubstrat (202, 203), um die Paste auf der Druckwalze auf das Halbleitersubstrat (202, 203) zu übertragen.

**9.** Verfahren nach Anspruch 7, wobei das Tiefdruckverfahren Folgendes umfasst: Vorbereiten eines Gummituchzylinders, der Rillen aufweist, die in einem vorbestimmten Muster gebildet sind, das dem der Frontelektrode (110) entspricht; Füllen der auf dem Gummituchzylinder gebildeten Rillen mit Paste für Elektrodenbildung; und Drehen des Gummituchzylinders auf einem Halbleitersubstrat (202, 203), um die Paste von dem Gummituchzylinder auf das Halbleitersubstrat (202, 203) zu übertragen.

**Revendications**

**1.** Pile solaire comprenant une électrode frontale (110), dans laquelle l'électrode frontale (110) est configurée dans une structure dans laquelle un motif comprenant une pluralité d'électrodes de grille disposées en parallèle et au moins une électrode collectrice de courant (120) croisant les électrodes de grille est formé sur un substrat semi-conducteur (202, 203), le courant introduit jusqu'aux électrodes de grille est déplacé jusqu'à et collecté dans l'électrode collectrice de courant (120), et la largeur de chacune des électrodes de grille va en augmentant vers l'électrode collectrice de courant (120),

dans laquelle la largeur de chacune des électrodes de grille va en augmentant de manière discontinue en proportion inverse de la distance depuis l'électrode collectrice de courant (120), et dans laquelle le motif comprend une première partie de motif (110A) et une seconde partie de motif (110B) au niveau de laquelle la largeur de chacune des électrodes de grille est inférieure à celle de chacune des électrodes de grille au niveau de la première partie de motif (110A),
**caractérisée en ce que**
les électrodes de grille de la première partie de motif (110A) et les électrodes de grille de la seconde partie de motif (110B) s'étendent le long d'une direction longitudinale des électrodes de grille,
au niveau de la première partie de motif (110A), la largeur de chacune des électrodes de grille est de 150 μm ou moins, et
des électrodes à dendrites (110C) sont situées entre les électrodes de grille de la première partie de motif (110A) et les électrodes de grille de la seconde partie de motif (110B) pour interconnecter deux électrodes de grille ou plus de la seconde partie de motif (110B) avec chaque électrode de grille de la première partie de motif (110A).

**2.** Pile solaire selon la revendication 1, dans laquelle les électrodes de grille font un angle droit par rapport à l'électrode collectrice de courant (120).

**3.** Pile solaire selon la revendication 1, dans laquelle la largeur de chacune des électrodes de grille va en augmentant de sorte que la largeur de chacune des électrodes de grille à une extrémité de celle-ci adjacente à l'électrode collectrice de courant (120) est 50 à 500 % plus grande que la largeur de chacune des électrodes de grille à l'autre extrémité de celle-ci distante de l'électrode collectrice de courant (120).

12

**4.** Pile solaire selon la revendication 1, dans laquelle la largeur de chacune des électrodes à dendrites (110C) est une à deux fois celle de chacune des électrodes de grille de la seconde partie de motif (110B).

**5.** Pile solaire selon la revendication 1, dans laquelle la largeur de chacune des électrodes de grille de la première partie de motif (110A) est 1,1 à 15 fois celle de chacune des électrodes de grille de la seconde partie de motif (110B) à l'intérieur d'une plage plus grande que celle de chacune des électrodes à dendrites (110C).

**6.** Pile solaire selon la revendication 1, dans laquelle la largeur de chacune des électrodes de grille de la seconde partie de motif (110B) est de 10 à 70 % de la longueur totale de chacune des électrodes de grille, la longueur de chacune des électrodes de grille de la première partie de motif (110A) est de 30 à 90 % de la longueur totale de chacune des électrodes de grille, et la longueur de chacune des électrodes à dendrites (110C) est de 10 % ou moins de la longueur totale de chacune des électrodes de grille.

**7.** Procédé de fabrication d'une pile solaire comprenant une électrode frontale (110) selon la revendication 1, dans lequel, lors de la formation d'un motif comprenant une pluralité d'électrodes de grille disposées en parallèle et au moins une électrode collectrice de courant (120) croisant les électrodes de grille sur un substrat semi-conducteur (202, 203), le procédé comprend :

(a) une impression d'une pâte sur un substrat semi-conducteur (202, 203) en utilisant un procédé d'héliogravure ou un procédé d'impression offset de sorte que les électrodes de grille présentent une largeur de 100 $\mu$m ou moins ; et
(b) un chauffage et/ou une pressurisation de la pâte pour durcir la pâte.

**8.** Procédé selon la revendication 7, dans lequel le procédé d'impression offset comprend : une préparation d'un substrat d'impression présentant des rainures formées dans un motif prédéterminé correspondant à celui de l'électrode frontale (110) ; un remplissage des rainures formées au niveau du substrat d'impression avec une pâte pour une formation d'électrodes ; une mise en rotation d'un cylindre d'impression sur le substrat d'impression pour transférer la pâte placée dans les rainures vers le cylindre d'impression ; et une mise en rotation du cylindre d'impression sur un substrat semi-conducteur (202, 203) pour transférer la pâte du cylindre d'impression vers le substrat semi-conducteur (202, 203).

**9.** Procédé selon la revendication 7, dans lequel le procédé d'héliogravure comprend : une préparation d'un cylindre porte-blanchet présentant des rainures formées dans un motif prédéterminé correspondant à celui de l'électrode frontale (110) ; un remplissage des rainures formées au niveau du cylindre porte-blanchet avec une pâte pour une formation d'électrodes ; et une mise en rotation du cylindre porte-blanchet sur un substrat semi-conducteur (202, 203) pour transférer la pâte du cylindre porte-blanchet vers le substrat semi-conducteur (202, 203).

FIG. 1

FIG. 2

FIG. 3

FIG. 4

FIG. 5

FIG. 6

FIG. 7

FIG. 8

FIG. 9

FIG. 10

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2006107892 A
- JP 57117662 U
- JP 6283736 A
- EP 1811576 A2

### Non-patent literature cited in the description

- Optimization of grid design for solar cells at different illumination levels. *CHEMTRONICS,* June 1989, vol. 4